# EUROPEAN PATENT APPLICATION

(11) **EP 4 796 278 A1**
(43) Date of publication of application: **26.08.2026**
(21) Application number: 26160028.2
(22) Date of filing: 23.02.2026
(51) Int. Cl.: B29B 17/02, B29B 17/04, H10F 19/80, B02C 23/10, B29L 9/00, B29L 31/34

(54) **METHOD FOR RECOVERING MATERIALS FROM A PHOTOVOLTAIC PANEL, AND RELATED PROCESSING LINE**

(30) Priority: 24.02.2025 IT 202500003549
(71) Applicant: Tialpi S.r.l., 13900 Biella (IT)
(72) Inventor: RAMON, Lodovico, 13862 Brusnengo (Biella) (IT)
(74) Representative: Vanzini, Christian

(57) **Abstract**

Method for recovering materials from a photovoltaic panel sandwich, the method comprising the following steps:
a) scraping the surface of an upper encapsulating layer (E2) of the photovoltaic panel sandwich by means of a first rotating milling cutter (18),
b) separating scraped particles between glass particles and particles of the plastic material of the encapsulating layer (E2),
c) heating a layer of photovoltaic cells (PC) of the photovoltaic panel sandwich,
d) removing the upper encapsulating layer (E2), the layer of photovoltaic cells (PC) and a lower encapsulating layer (E1) from a support sheet (BS) of the photovoltaic panel sandwich, by means of a second rotating milling cutter (38),
e) separating removed particles between particles of metallic material of conductors (CP) and particles of mixed material of the encapsulating layers (E1, E2) and of the photovoltaic cells (PC).

## Description

The present invention relates in general to methods for recovering materials present in decommissioned photovoltaic panels.

Nowadays, the current treatment mode of end-of-life photovoltaic panels consists in the recovery of electrical cables and aluminum (17% by weight) and in the subsequent grinding of the residual panel (83% by weight) in such a way as to obtain a granulate of centimeter dimensions that may be used, in small part, as an inert material or destined for landfill, since it is a mixture of glass, plastic, silicon without any commercial value.

It must be said that on the market there are partial recovering techniques for glass, but without the possibility of reusing it.

EP 2998038 Al describes a method and an apparatus for detaching the glass from a photovoltaic panel laminate, the laminate comprising an encapsulating layer containing photovoltaic cells, a front glass sheet and a back sheet joined to the encapsulating layer on opposite surfaces thereof. The known method provides for heating the photovoltaic panel laminate by means of infrared heaters, to bring the encapsulating layer to an operating temperature between 70 and 150°C, in such a way as to cause the softening thereof (with a temperature gradient from 5 to 35°C between the opposite faces of the laminate), and for detaching the glass from the encapsulating layer heated to the operating temperature.

The decommissioned photovoltaic panels shall be prepared in such a way as to be able to be subjected to a thermomechanical treatment such as that described in EP 2998038 A1; in particular, components, such as the frame and the electrical connector, which may possibly be subjected to other treatments for the recovery thereof, shall be removed beforehand. A method for processing decommissioned photovoltaic panels is described in EP 4324614 A1 of the same Applicant. At the end of the process described in EP 4324614 A1, a semi-finished product is obtained consisting of a photovoltaic panel sandwich including:
- a laminated body comprising a first encapsulating layer and a second encapsulating layer of plastic material, between which there is a layer of photovoltaic cells coupled to a plurality of conductors, and a support sheet of plastic material joined to the first encapsulating layer, and
- glass residues possibly adhering to a surface of the second encapsulating layer.

Metallic silicon, mono- or polycrystalline, of which photovoltaic cells are generally made, it is considered among the SRM (Strategic Raw Materials), namely, it is a material important for use in technologies related to energy and digitalization. Since the production of silicon is very energy-intensive, it is fundamental to aim at recycling, and the photovoltaic panels are an important source of supply for the circular economy. Copper is also considered a SRM.

It is an object of the present invention to provide a way to industrialize the processes for recovering the aforesaid metallic materials.

Such object is achieved in accordance with the invention by a method for recovering materials from a photovoltaic panel sandwich, the photovoltaic panel sandwich including:
- a laminated body comprising a first encapsulating layer and a second encapsulating layer of plastic material, between which there is a layer of photovoltaic cells coupled to a weft of conductors, and a support sheet of plastic material joined to the first encapsulating layer,
- glass residues possibly adhering to a surface of the second encapsulating layer,
in which the method comprises the following steps:
a) scraping the surface of the second encapsulating layer by means of a first rotating milling cutter,
b) sucking particles scraped away from the surface of the second encapsulating layer, and extracting said scraped particles from a first suction air flow, by separating them between glass particles and particles of the plastic material of the second encapsulating layer,
c) heating the layer of photovoltaic cells in such a way as to create a differential of thermal expansion between the material of the photovoltaic cells and the plastic material of the support sheet,
d) removing the second encapsulating layer, the layer of photovoltaic cells with the weft of conductors and the first encapsulating layer from the support sheet by means of a second rotating milling cutter,
e) sucking particles removed from the support sheet, and extracting said removed particles with a second suction air flow, by separating them between particles of metallic material from the conductors and particles of mixed material from the encapsulating layers and the photovoltaic cells.

Features and advantages of the method according to the invention will become more apparent from the following detailed description of an embodiment of the invention, made with reference to the accompanying drawings, provided purely by way of illustration and not limitation, in which
Figure 1 is a side elevation view of a part of a processing line for implementing the method in accordance with the invention;
Figure 2 is a front view of a part of the processing line of Figure 1;
Figure 3 is a sectional view of the part of the processing line of Figure 2. The symbols I-I, II-II, III-III and IV-IV denote different horizontal section planes identified in Figure 2,
Figures 4 and 5 are simplified side elevation views of the processing line of Figure 2, which show different operating positions of a movable carriage,
Figure 6 is a sectional view of a photovoltaic panel sandwich,
Figure 7 is a front view of a further component of the processing line of Figure 1, and
Figure 8 is a side elevation view of the component of Figure 7.

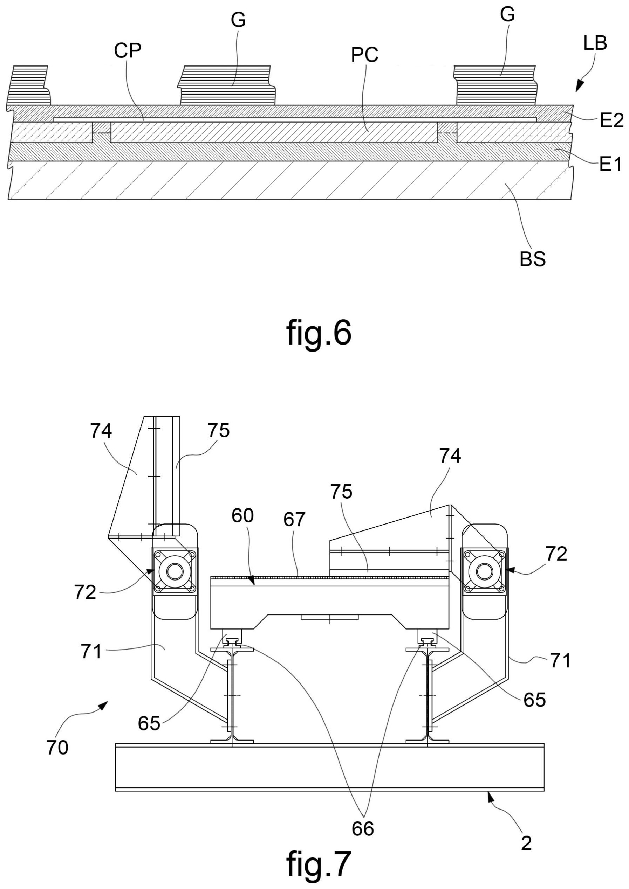

With reference to the Figures, a processing line for recovering materials from a photovoltaic panel sandwich is shown. A photovoltaic panel sandwich is a rectangular sheet which may have dimensions of about 1 m x 1.60 m and a thickness of about 1.6 mm, and is diagrammatically shown in Figure 6. Such photovoltaic panel sandwich includes:
- a laminated body LB comprising a first encapsulating layer E1 and a second encapsulating layer E2 of plastic material, between which there is a layer of photovoltaic cells PC coupled to a plurality of conductors CP, and a support sheet BS of plastic material joined to the first encapsulating layer E1,
- glass residues G possibly adhering to a surface of the second encapsulating layer E2.

The support sheet BS, generally referred to as "backsheet", consists of some thin films of different plastics, and may have a thickness of about 0.6 mm.

The first encapsulating layer E1 and the second encapsulating layer E2 are made of transparent plastic, for example ethylene vinyl acetate (EVA), and may each have a thickness of about 0.3 mm.

The layer of photovoltaic cells PC is commonly of mono- or polycrystalline silicon (but it may be of other semiconductor material) and may have a thickness of about 0.2-0.3 mm.

The plurality of conductors CP generally consists of a weft of conductors, generally known as busbars, connected to one another by a warp of silver frit. Such conductors are generally of metallic material, in particular copper.

The glass residues G may have a size below one millimeter.

The sandwich described above is a semi-finished product resulting from the processing of decommissioned photovoltaic panels. A processing process that allows to obtain such sandwich is described in EP 4324614 A1 of the same Applicant.

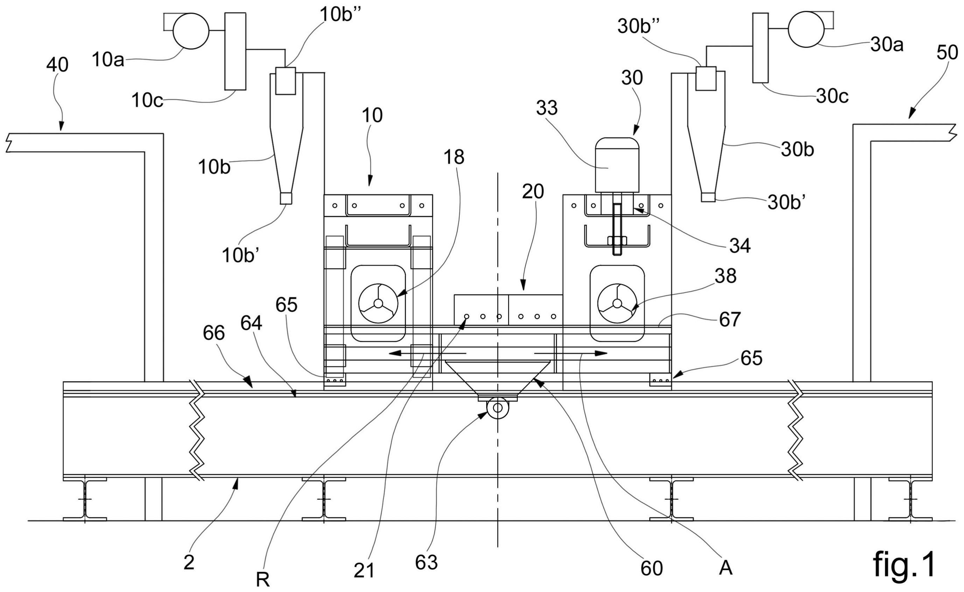

With reference to Figures 1-5 and 7-8, a processing line is shown which essentially comprises, in sequence, one after the other, a glass removal station or machine 10, a heating station 20 and a sandwich delamination station or machine 30. The processing line further comprises a Cartesian power supply robot 40 (shown only in Figure 1) configured to load the sandwiches at the inlet of the processing line, and a Cartesian end-of-line robot 50 (shown only in Figure 1) to transfer, outside the processing line, the backsheets that remain from the processing carried out on the sandwiches. The glass removal station or machine 10, the heating station 20 and the sandwich delamination station or machine 30 are supported by a stationary structure 2 of the processing line.

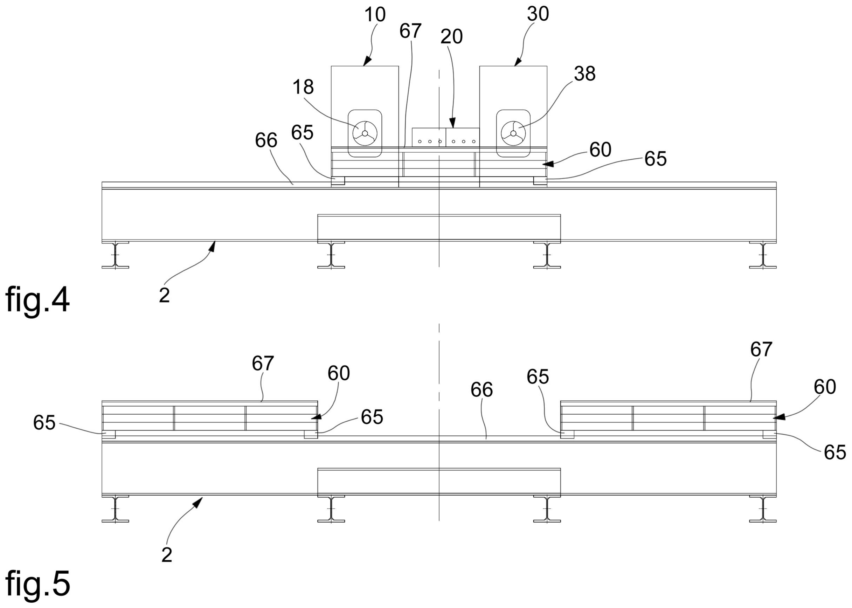

The single photovoltaic panel sandwich is advanced along a horizontal direction of movement that goes from an entry position of the processing line, at the Cartesian power supply robot 40, to an outlet position, at the Cartesian end-of-line robot 50. In this regard, the photovoltaic panel sandwich is fastened to a motorised carriage 60. In Figure 4, the motorised carriage 60 is shown in a working position along the processing line. In Figure 5 the motorised carriage 60 is shown in the two inlet and outlet positions at the ends of the processing line. For simplicity, in Figure 5, the machines provided along the processing line are not shown. It should be noted that the length of the entry position of the processing line is substantially equal to the length of the photovoltaic panel sandwich. In an analogous manner, the length of the stretch of the processing line between the glass removal station 10 and the sandwich delamination station 30 has a length substantially equal to the length of the photovoltaic panel sandwich. Furthermore, the length of the entry position of the processing line is substantially equal to the length of the photovoltaic panel sandwich. Overall, therefore, the processing line has a length equal to about three times the length of the entry position of the processing line, and is substantially equal to the length of the photovoltaic panel sandwich.

If the processing line described above is arranged downstream of the processing line described in EP 4324614 A1, the Cartesian power supply robot 40 may pick up the sandwiches from a warehouse originating from the processing line described in EP 4324614 A1. The Cartesian power supply robot 40 may operate on two Cartesian axes: Y for translation and Z for lifting, with a gripping head provided with a suction-cup arm to grasp the individual sandwiches. Preferably, the gripping head may be rotated by 180° in such a way as to be able to overturn the sandwich. This is due to the fact that, at the end of the processing line described in EP 4324614 A1, the sandwich presents the backsheet side upwards, while for the processing line described herein it is necessary that the backsheet side of the sandwich be facing downwards, i.e., with the arrangement shown in Figure 6.

The Cartesian power supply robot 40 places the photovoltaic panel sandwich on the motorised carriage 60 when the motorised carriage 60 is in the entry position shown on the left in Figure 5.

The motorised carriage 60 is movable along a guide extending along the movement direction identified by the arrows A, R in Figure 1. In this regard, the motorised carriage 60 comprises a gear motor 61 arranged on board the motorised carriage 60, and operable to move the motorised carriage 60 along the horizontal direction of movement. An output shaft 62 of the gear motor 61 is provided with a pair of gear wheels 63 arranged on opposite sides of the motorised carriage 60, and coupled to respective racks 64 arranged on the stationary structure 2 of the movement line. Furthermore, the motorised carriage 60 comprises a pair of sliding bearings 65 arranged on opposite sides of the motorised carriage 60, and coupled to respective horizontal guides 66 arranged on the stationary structure 2 of the movement line.

The motorised carriage 60 further comprises a support grid 67 configured to support the photovoltaic panel sandwich. The photovoltaic panel sandwich is fastened to the support grid 67, and therefore to the motorised carriage 60, by means of vacuum-assisted adhesion. To this end, the support grid 67 is connected to a suction system (not shown) to cause the sandwich to adhere to the surface of the support grid 67. The adhesion force must be such as to counteract the tangential tensile stress induced by the operations that will be described below.

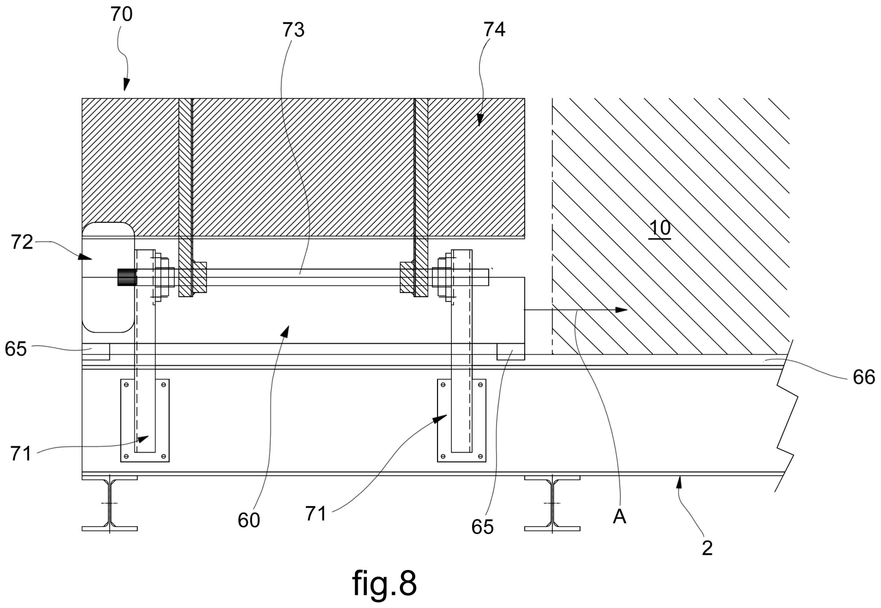

To facilitate the adhesion of the sandwich to the support grid 67 when the sandwich is placed on the motorised carriage 60 at the entry position of the processing line, at such entry position a clamping device 70 may be provided, which is not shown in Figures 1-5, but only in Figures 7-8. In Figure 8, the area filled with hatching shows the area occupied by the glass removal station or machine 10.

The clamping device 70 comprises two pairs of support arms 71 fastened to the stationary structure 2 of the processing line, more specifically to the part thereof that supports the horizontal guides 66, and arranged on opposite sides with respect to a central vertical plane of the processing line. A respective rotating actuator 72 is fastened to one of the support arms 71 of each pair of arms. A respective output shaft 73 of each rotating actuator 72 is supported by the respective pair of support arms 71, pivotally about an axis parallel to the direction of movement of the motorised carriage 60. A respective clamping jaw 74 is fastened to such output shaft 73, which is therefore rotatable between a lowered operating position, shown for the jaw 74 on the left in Figure 7, and a raised rest position, shown for the jaw 74 on the right in Figure 7.

Each of the jaws 74 is provided, on a surface thereof intended to come into contact with the sandwich, with a shock-absorbing material or element 75, for example an inflatable pad.

The function of the clamping device 70 is to make the sandwich adhere perfectly to the surface of the support grid 67, in such a way as to facilitate the suction system connected to such support grid 67 in obtaining adhesion, by applying vacuum, of the sandwich to the support grid 67. Once such adhesion is obtained, the clamping device 70 may be brought from the working position thereof to the resting position thereof.

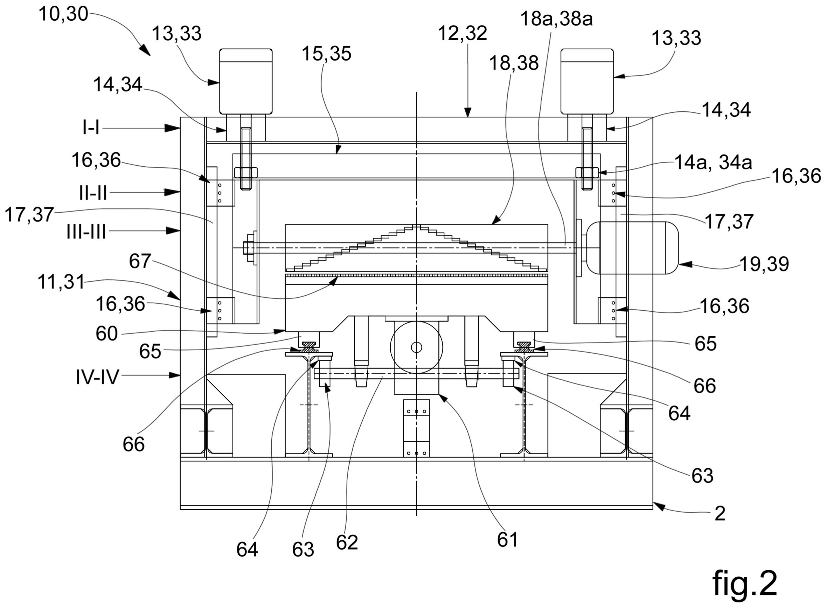

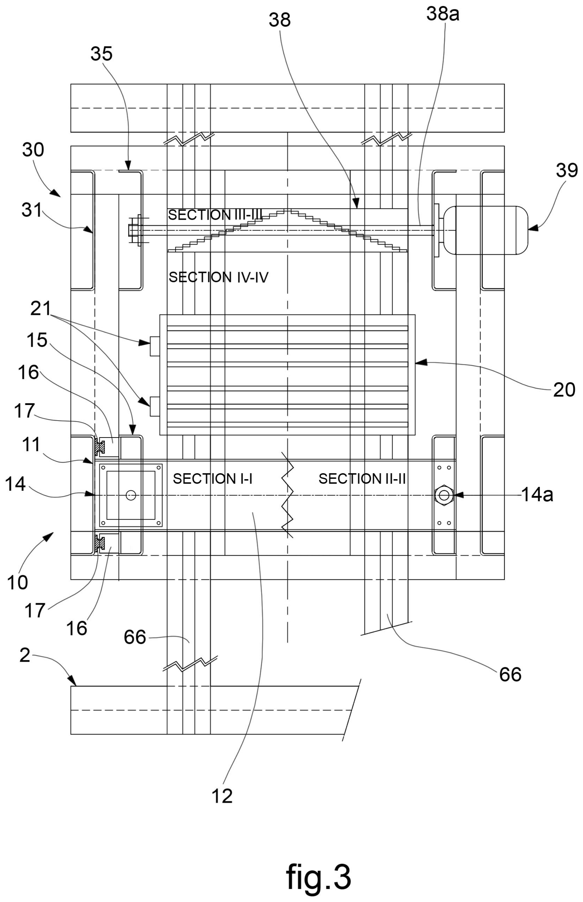

The glass removal station or machine 10 and the sandwich delamination station or machine 30 have substantially identical structures, and therefore will be both described with reference to Figures 2 and 3.

The glass removal station or machine 10 comprises a gantry structure 11 fastened to the stationary structure 2 of the processing line, and arranged to straddle the horizontal guides 66. The gantry structure 11 comprises a horizontal support beam 12, which supports a pair of motors 13 arranged on opposite sides of the gantry structure 11. Each of the motors 13 is coupled to a micrometric movement mechanism 14, for example a worm screw mechanism. The movable part 14a of the micrometric movement mechanism 14 is fastened to a vertically movable support 15. On opposite sides of the support 15, respective sliding bearings 16 are arranged, which are coupled to vertical guides 17 fastened to the gantry structure 11 and arranged on opposite sides thereof.

The support 15, in turn, supports a rotating milling cutter 18, whose shaft 18a receives the rotating motion from a gear motor 19 arranged on board the support 15. The rotating milling cutter 18 is therefore rotatable about a horizontal axis orthogonal to the direction of movement of the motorised carriage 60. The rotating milling cutter 18 is, in particular, a cylindrical milling cutter provided with cutting edges capable of removing the glass from the sandwich.

The glass removal station or machine 10 performs a surface cleaning of the sandwich by delamination using the rotating milling cutter 18. The operation consists in scraping the glass residues (in general, from 200 to 500 grams per sandwich may be obtained), which are captured by a suction device 10a connected to a cyclone separator 10b and to a bag filter 10c, integral with the glass removal station or machine 10 (diagrammatically shown in Figure 1).

It is the object of the cyclone separator 10b to separate glass from any plastic material originating from the second encapsulating layer E2 and accidentally removed during the surface cleaning process. The glass particles exit by gravity from a first outlet 10b' of the cyclone separator 10b, while the suction air flow with the plastic particles exits from a second outlet 10b" of the cyclone separator 10b. Such plastic particles are captured by the bag filter 10c associated with the second outlet 10b" of the cyclone separator 10b, which therefore returns the cleaned suction air. The two products, glass and plastic, may be recovered in bags coupled to star valves (not shown). The separation of glass and plastic may occur in a different manner from what described above.

The heating station 20 comprises a bank of short-wave infrared lamps 21 that has the function of heating the material of the photovoltaic cells to a temperature such as to cause, due to the different thermal expansion of the material of the photovoltaic cells with respect to that of the backsheet, surface stresses that promote the subsequent tangential delamination. In the case where the material of the photovoltaic cells is silicon, such a temperature may be 60°C.

The heating station 20 is fastened to the stationary structure 2 of the processing line. The motorised carriage 60 slides below the bank of infrared lamps 21. Alternative heating methods are possible.

The sandwich delamination station or machine 30 comprises a gantry structure 31 fastened to the stationary structure 2 of the processing line, and arranged to straddle the horizontal guides 66. The gantry structure 31 comprises a horizontal support beam 32, which supports a pair of motors 33 arranged on opposite sides of the gantry structure 31. Each of the motors 33 is coupled to a micrometric movement mechanism 34, for example a worm screw mechanism. The movable part 34a of the micrometric movement mechanism 34 is fastened to a vertically movable support 35. On opposite sides of the support 35, respective sliding bearings 36 are arranged, which are coupled to vertical guides 37 fastened to the gantry structure 31 and arranged on opposite sides thereof.

The support 35, in turn, supports a rotating milling cutter 38, whose shaft 38a receives the rotating motion from a gear motor 39 arranged on board the support 35. The rotating milling cutter 38 is therefore rotatable about a horizontal axis orthogonal to the direction of movement of the motorised carriage 60. The rotating milling cutter 38 is, in particular, a cylindrical milling cutter provided with cutting edges capable of removing the materials of which the sandwich is made.

The sandwich delamination station or machine 30 performs a removal of the photovoltaic cell layer PC and of the two encapsulating layers E2, E1 (above and below the photovoltaic cell layer) with the rotating milling cutter 38. The operation consists of scraping such a set of layers, which may have a thickness of 900 microns. The particles produced during such operation are captured by a suction device 30a connected to a cyclone separator 30b and to a bag filter 30c, integral with the sandwich delamination station or machine 30 (diagrammatically shown in Figure 1).

It is the object of the cyclone separator 30b to separate the metallic material (copper) of the conductors CP from the lighter material of the photovoltaic cells and of the encapsulating layers. The particles of metallic material exit by gravity from a first outlet 30b' of the cyclone separator 30b, while the suction air flow with the particles of the photovoltaic cells and of the encapsulating layers exits from a second outlet 30b" of the cyclone separator 30b. Such particles are captured by the bag filter 30c associated with the second outlet 30b" of the cyclone separator 30b, which therefore returns the cleaned suction air. The two products, metallic material and mixed silicon/plastic, may be recovered in bags coupled to star valves (not shown). The separation of the materials may occur in a different manner from that described above.

The advancing of the motorised carriage 60 is programmed according to the features of the sandwich to be processed and is synchronized with the vertical movement of the machines 10 and 30. At the end of the operation of detaching the glass and the encapsulating layers with the photovoltaic cells, the motorised carriage proceeds until reaching the exit position (shown on the right in Figure 5), in such a way as to prepare the unloading of the residual backsheet.

The Cartesian end-of-line robot 50 then performs the unloading of the backsheet from the processing line, allowing the motorised carriage 60 to reverse the motion to return to the entry position. The Cartesian end-of-line robot 50 may operate on two Cartesian axes: Y for translation and Z for lifting, with a gripping head provided with a suction-cup arm to grasp the individual backsheets.

In conclusion, at the end of the line described above it is possible to recover glass in millimetric size, surface plastic material of the second encapsulating layer E2 in millimetric size, metallic material (copper) in strip size (busbar), surface plastic material of the encapsulating layers E1, E2 and material of photovoltaic cells in centimetric size, and backsheet in sheets.

## Claims

1. Method for recovering materials from a photovoltaic panel sandwich, the photovoltaic panel sandwich including:
- a laminated body (LB) comprising a first encapsulating layer (E1) and a second encapsulating layer (E2) of plastic material, between which there is a layer of photovoltaic cells (PC) coupled to a plurality of conductors (CP), and a support sheet (BS) of plastic material joined to the first encapsulating layer (E1),
- glass residues (G) possibly adhering to a surface of the second encapsulating layer (E2),
wherein the method comprises the following steps:
a) scraping the surface of the second encapsulating layer (E2) by means of a first rotating milling cutter (18),
b) sucking particles scraped away from the surface of the second encapsulating layer (E2), and extracting said scraped particles from a first suction air flow, by separating them between glass particles and particles of the plastic material of the second encapsulating layer (E2),
c) heating the layer of photovoltaic cells (PC) in such a way as to create a differential of thermal expansion between the material of the photovoltaic cells and the plastic material of the support sheet (BS),
d) removing the second encapsulating layer (E2), the layer of photovoltaic cells (PC) with the plurality of conductors (CP) and the first encapsulating layer (E1) from the support sheet (BS) by means of a second rotating milling cutter (38),
e) sucking particles removed from the support sheet (BS), and extracting said removed particles with a second suction air flow, by separating them between particles of metallic material from the conductors (CP) and particles of mixed material from the encapsulating layers (E1, E2) and the photovoltaic cells (PC).

2. Method according to claim 1, wherein step b) includes a first cyclone separator (10b) having a first outlet (10b') for collecting the glass particles, and a second outlet (10b'') coupled to a first filter (10c) for separating the particles of the plastic material of the second encapsulating layer (E2) from the first air flow.

3. Method according to claim 1 or 2, wherein step e) comprises a second cyclone separator (30b) having a first outlet (30b') for collecting the metallic material particles of the conductors, and a second outlet (30b") coupled to a second filter (30c) for separating the particles of mixed material of the encapsulating layers (E1, E2) and of the photovoltaic cells (PC) from the second air flow.

4. Method according to any of the preceding claims, during which the photovoltaic panel sandwich is advanced along a horizontal direction of movement (A).

5. Method according to claim 4, wherein the photovoltaic panel sandwich is attached by vacuum-assisted adhesion to a motorised carriage (60) movable along a guide (66) extending along said horizontal direction of movement (A).

6. Method according to claim 5, wherein clamping means (74), arranged at an entry position of said guide (66), are operable to temporarily clamp the photovoltaic panel sandwich to the motorised carriage (60), before applying a vacuum to adhere the photovoltaic panel sandwich to the motorised carriage (60).

7. Method according to claim 2 in combination with any of claims 4 to 6, wherein the first rotating milling cutter (18) is able to rotate about a horizontal axis orthogonal to said horizontal direction of movement (A).

8. Method according to claim 7, wherein the first rotating milling cutter (18) is mounted on a first motorised support (15) that is vertically movable and provided with micrometric movement.

9. Method according to claim 3 in combination with any of claims 4 to 5, wherein the second rotating milling cutter (38) is able to rotate about a horizontal axis orthogonal to said horizontal direction of movement (A).

10. Method according to claim 9, wherein the second rotating milling cutter (38) is mounted on a second motorised support (35) that is vertically movable and provided with micrometric movement.

11. Processing line configured to carry out a method according to any of the preceding claims, comprising
a first rotating milling cutter (18) operable to scrape the surface of the second encapsulating layer (E2),
first suction means (10d) operable to suck particles scraped away from the surface of the second encapsulating layer (E2),
first separator means (10b, 10c) configured to extract said scraped particles from a first suction air flow, by separating them between glass particles and particles of the plastic material of the second encapsulating layer (E2),
heating means (20) operable to heat the layer of photovoltaic cells (PC) in such a way as to create a differential of thermal expansion between the material of the photovoltaic cells and the plastic material of the support sheet (BS),
a second rotating milling cutter (38) operable to remove the second encapsulating layer (E2), the layer of photovoltaic cells (PC) with the plurality of conductors (CP) and the first encapsulating layer (E1) from the support sheet (BS),
second suction means (30d) operable to suck particles removed from the support sheet (BS), and
second separator means (30b, 30c) configured to extract said removed particles from a second suction air flow, by separating them between particles of metallic material from the conductors (CP) and particles of mixed material from the encapsulating layers (E1, E2) and the photovoltaic cells.
